# EUROPÄISCHE PATENTSCHRIFT

(11) **EP 0 539 900 B1**
(45) Veröffentlichungstag und Bekanntmachung des Hinweises auf die Patenterteilung: **12.08.1998**
(21) Anmeldenummer: 92118268.9
(22) Anmeldetag: 26.10.1992
(51) Int. Cl.: G01R 31/02

(54) **Verfahren zum Erfassen von Isolationsfehlern und Sparktester zur Durchführung dieses Verfahrens**
Insulation fault detection process and spark tester for executing the process
Procédé pour déterminer des fautes d'isolation et testeur d'étincelles pour executer ce procédé

(30) Priorität: 29.10.1991 CH 3154/91
(43) Veröffentlichungstag der Anmeldung: 05.05.1993
(73) Patentinhaber: ZUMBACH ELECTRONIC AG, CH-2552 Orpund (CH)
(72) Erfinder: Nopper, Peter, CH-3250 Lyss (CH)
(74) Vertreter: Jaeger, Klaus, Dr.

(56) Entgegenhaltungen:
- DE-A- 1 516 146
- DE-C- 975 957
- GB-A- 1 212 703
- GB-A- 1 570 724
- GB-A- 2 062 250
- US-A- 2 360 944
- US-A- 3 462 682

## Beschreibung

Die Erfindung betrifft ein Verfahren zum Erfassen von Isolationsfehlern gemäß dem Oberbegriff des Anspruchs 1 und einen Sparktester nach dem Oberbegriff des Anspruchs 7, wie z.B. aus der DE-C- 975 957 bekannt.

Zum Erfassen von Isolationsfehlern an durchlaufenden. Drähten oder Kabeln werden sogenannte Sparktester eingesetzt, in welchen unter verhältnismässig hoher Spannung stehende Elektroden lose am durchlaufenden Draht oder Kabel anliegen, während der oder die Leiter des Drahtes, bzw. Kabels geerdet sind. Als Elektroden werden im allgemeinen lose Ketten oder aber kleine Drahtbürsten verwendet. Beide Elektrodenarten vermögen nicht voll zu befriedigen. Im Falle von Ketten resultiert eine ungleichmässige und unsichere Verteilung des Spannungszustandes, bzw. der Korona an der Isolationsoberfläche. Im Falle von Metallbürsten entstehen durch Abrieb sehr spitze und scharfkantige Metallteile, welche sich in der Isolationsoberfläche einhaken und damit zu Kurzschlüssen führen können. Das ist ganz besonders der Fall bei der Prüfung von geschäumten Isolationen.

Bei bekannten Sparktestern ist häufig lediglich ein Relais vorgesehen, welches bei Isolationsfehlern und dadurch verursachten Durchschlägen zwischen den Elektroden und dem Leiter des Drahtes oder Kabels auf den erhöhten Strom anspricht und ein Zählwerk betätigt. Auch diese Anordnung erweist sich als nachteilig, weil zur Erzielung genügender Empfindlichkeit mit verhältnismässig hohen Prüfspannungen gearbeitet werden muss. Diese Notwendigkeit besteht auch deshalb, weil unter Umständen erhebliche Spannungsschwankungen auftreten können. Bei der Prüfung mit Wechselspannung können infolge variabler Kapazität zwischen den Prüfelektroden und dem Leiter des zu prüfenden Objektes erhebliche Spannungsschwankungen auftreten; sei es, dass die Spannung zu stark absinkt; sei es, dass infolge Resonanz unerwünschte Spannungsüberhöhungen auftreten. Im Falle einer Prüfung mit Gleichspannung kann durch Ladungstransport an der Isolationsoberfläche eine variable Belastung und damit eine unerwünschte Spannungsänderung auftreten.

Ziel vorliegender Erfindung ist es, ein Verfahren und einen Sparktester anzugeben, bei welchen die obenerwähnten Nachteile vermieden sind. Dies Ziel wird zunächst mit den Massnahmen gemäss Anspruch 1 erreicht. Es zeigt sich, dass Bürsten aus Carbonfasern eine sehr hohe Anzahl von extrem feinen und geschmeidigen Fasern von beispielsweise 0,007 mm Durchmesser aufweisen können, so dass mit einer gewissen Anzahl solcher Bürsten eine sehr gleichmässige Bedeckung der Isolationsoberfläche möglich ist. Die sehr hohe Anzahl extrem feiner Fasern ergibt eine sehr gleichmässige Koronaausbildung, bzw. Spannungsverteilung an der Isolationsoberfläche, was wiederum gestattet, mit verhältnismässig niedrigerer Spannung zu arbeiten.

Die Prüfspannung wird auf einen Sollwert im Bereich von 800 bis 5000 V geregelt. Es wird hier ein gewisser Kombinationseffekt insofern erzielt, als dank dem Einsatz von Carbonfaser-Bürsten als Elektroden an der Messstelle gleichmässige, konstante Bedingungen geschaffen werden können, die ihrerseits eine Spannungsregelung erleichtern und andererseits können durch die Spannungsregelung die Bedingungen an der Messstelle konstant gehalten werden.

Wird eine Wechselspannung angelegt, kann vorzugsweise auch die Frequenz geregelt werden. Die dabei unter bestimmten Voraussetzungen erzielbaren Vorteile werden unten eingehender erläutert.

Eine weitere Massnahme zur Erhöhung der Zuverlässigkeit der Messung trotz dem Einsatz von verhältnismässig niedrigen Prüfspannungen kann darin bestehen, dass aus dem Messignal mittels Filter Störsignale eliminiert werden. Damit kann die Zuverlässigkeit der Messung weiter erhöht werden.

Vorzugsweise können ferner die bei Durchschlägen auftretenden Impulse mit einem von der Messspannung abhängigen Ansprechniveau erfasst werden. Die Messspannung wird in Abhängigkeit vom Messobjekt, insbesondere der Dicke der Isolation, verschieden hoch gewählt, und es ist daher angezeigt, bei höherer Messspannung ein höheres Ansprechniveau zu wählen, damit nicht Störsignale zu einem Ansprechen führen und damit das Messergebnis verfälschen können.

Die Erfindung wird nun anhand der Zeichnung näher erläutert:
Fig. 1 zeigt schematisch ein Beispiel einer Elektrodenanordnung an einem erfindungsgemässen Sparktester,
Fig. 2 zeigt die Schaltung eines mit Gleichspannung arbeitenden Sparktesters,
Fig. 3 zeigt das Schaltschema eines mit Wechselspannung arbeitenden Sparktesters,
Fig. 4 zeigt ein Schaltungsbeispiel von Filtern kombiniert mit einer Regelung des Ansprechniveaus,
Fig. 5 zeigt schematisch eine weitere Ausführungsform der Elektrodenanordnung, und
Fig. 6 und 7 zeigen eine Elektrodenanordnung für flache Prüfobjekte und eine weitere Variante.

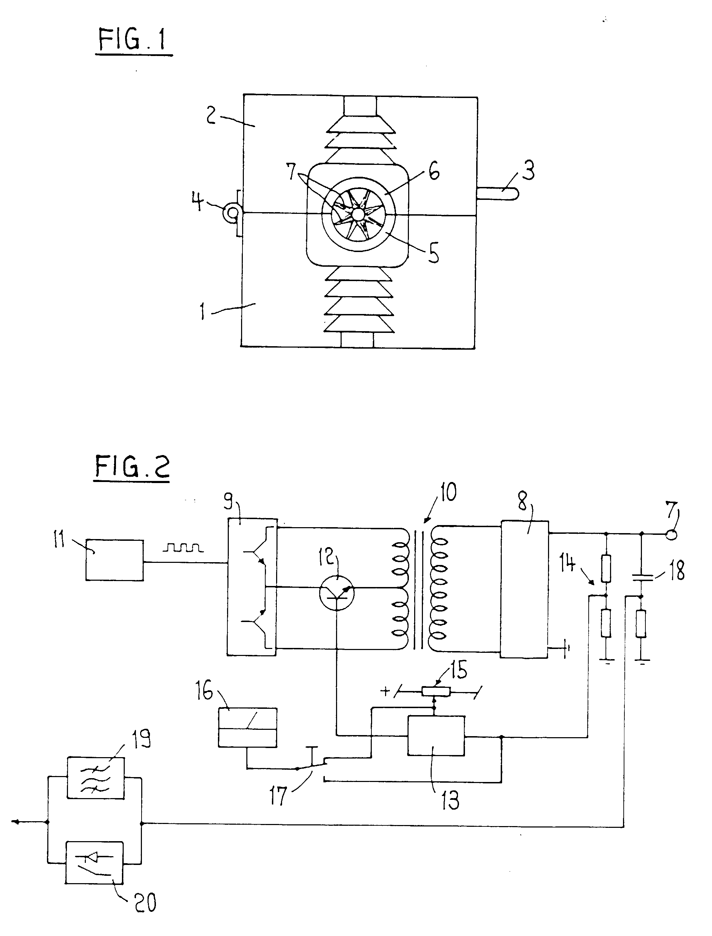

Fig. 1 zeigt zwei Gehäuseteile 1 und 2. Mittels eines Griffes 3 kann der obere Gehäuseteil 2 angehoben und um ein Scharnier 4 hochgeschwenkt werden. An den beiden Gehäuseteilen 1 und 2 sind halbkreisförmige Elektrodenträger 5, bzw. 6 befestigt, an welchen radial nach innen gerichtete Carbonfaser-Bürsten 7 befestigt sind.

Im dargestellten geschlossenen Zustand der Gehäuseteile 1 und 2 bilden die Carbonfasern der einzelnen Bürsten 7 mit ihren inneren feinen Enden einen praktisch gleichmässigen, zusammenhängenden Filz von Fasern, die gleichmässig gegen die Aussenfläche der Isolation eines in Fig. 1 nicht dargestellten, in der gemeinsamen Achse der Ringhälften 5 und 6 durchlaufenden Messobjektes, beispielsweise eines Drahtes oder eines Kabels anliegen. Die Elektrodenträger 5 und 6 und damit die Elektroden 7 können über nicht dargestellte isolierte Zuleitungen unter Spannung gesetzt werden, und Durchschläge zwischen den Elektroden und dem Leiter des durchgeführten Messobjektes werden in später beschriebener Weise erfasst und gezählt. Zum Einführen eines neuen Messobjektes oder für Wartungsarbeiten können die Gehäuseteile 1 und 2 wie erwähnt geöffnet werden.

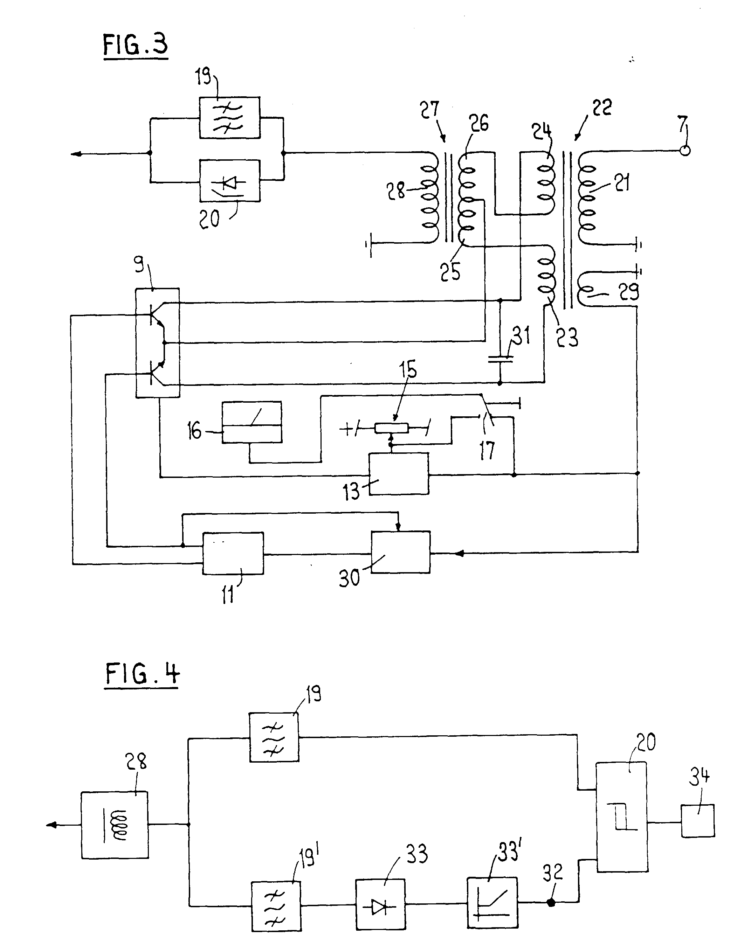

Fig. 2 zeigt die Schaltung eines mit Gleichspannung arbeitenden Sparktesters. Die Elektrode ist schematisch dargestellt und mit 7 bezeichnet. Ihr wird die Prüfspannung von 800 bis 5000 Volt aus einem Gleichspannungsgenerator 8 zugeführt. Dieser Hochspannungsgenerator weist im übrigen einen Leistungsverstärker 9 mit einem Hochspannungstransformator 10 auf. Der Leistungsverstärker wird durch einen Oszillator 11 angesteuert. Zwischen dem Leistungsverstärker 9 und dem Transformator 10 ist ein Regelelement 12 angeordnet, das mit dem Ausgang eines Spannungsreglers 13 verbunden ist. Der Eingang dieses Spannungsreglers ist mit einem Spannungsteiler 14 verbunden, der mit der Messelektrode 7 verbunden ist. Der Spannungsregler 13 weist im übrigen einen Sollwerteingang auf, der mit einem Sollwertgeber 15 verbunden ist. Eine Anzeige 16 kann mittels eines Schalters 17 mit dem Sollwert am Geber 15 oder mit dem Istwert am Spannungsteiler 14 verbunden werden. Die Messelektrode 7 ist über einen Kondensator 18 mit einem Bandpassfilter 19 und einem Ansprechniveauregler 20 verbunden. Am Ausgang der Schaltung 19, 20, die noch eingehender beschrieben wird, erscheinen Messimpulse beim Durchschlag zwischen der Messelektrode 7 und dem Leiter eines Messobjektes. Diese Ausgangsimpulse werden gezählt, und es kann ein Alarm ausgelöst werden.

Die Arbeitsweise der Schaltung nach Fig. 2 ergibt sich weitgehend aus dem Schema. Entsprechend der Stellung des Sollwertgebers 15 erfolgt eine automatische Spannungsregelung auf diesen Sollwert, der zur Kontrolle angezeigt werden kann. Es ist damit auch möglich, wachsende Spannungen für verschiedenartige Messobjekte am Sollwertgeber 15 einzustellen und mittels der Anzeige 16 zu kontrollieren, worauf eine automatische Regelung auf die gewählte Spannung erfolgt. Durch Umschalten des Schalters 17 kann jeweils geprüft werden, ob die eingestellte Spannung auch wirklich an der Messelektrode 7 erscheint. Die Funktion der Schaltungsteile 19 und 20 wird später erläutert.

In Fig. 3 sind entsprechende Schaltelemente gleich bezeichnet wie in Fig. 2. Die Messelektrode 7 ist direkt mit der Hochspannungswicklung 21 eines Hochspannungstransformators 22 verbunden. Die Primärwicklungen 23 und 24 des Transformators 22 sind in Serie geschaltet mit Primärwicklungen 25 und 26 eines Messtransformators 27, dessen Sekundärwicklung 28 mit den Kreisen 19 und 20 verbunden ist. Der Hochspannungstransformator 22 weist eine Messwicklung 29 auf, welche mit dem Spannungsregler 13 und einem Phasendetektor 30 verbunden ist. Der Spannungsregler 13 wirkt auf den geregelten Leistungsverstärker 9. Der Phasendetektor 30 vergleicht die Phase des durch einen Kondensator 31 zu einem Schwingkreis ergänzten Primärkreises des Hochspannungstransformators mit der Phase des Oszillators 11 und regelt dessen Frequenz in Abhängigkeit von der Phasenlage auf Resonanz. Die Rückwirkung der Messgutimpedanz auf die Primärwicklung bedingt in dieser Schaltung eine Phasenverschiebung zwischen Oszillator - und Resonanzkreisfrequenz. Die Frequenzregelung erfolgt derart, dass die Resonanzbedingung im Schwingkreis, gebildet aus der Primärwicklung des Hochspannungstransformators (22) und einem Abstimmkondensator (31) dauernd erfüllt ist. Das Resonanzprinzip erlaubt es, in einem gewissen Belastungsbereich die erforderliche Hochspannung mit einem minimalen Leistungsaufwand und minimaler Verlustleistung zu realisieren.

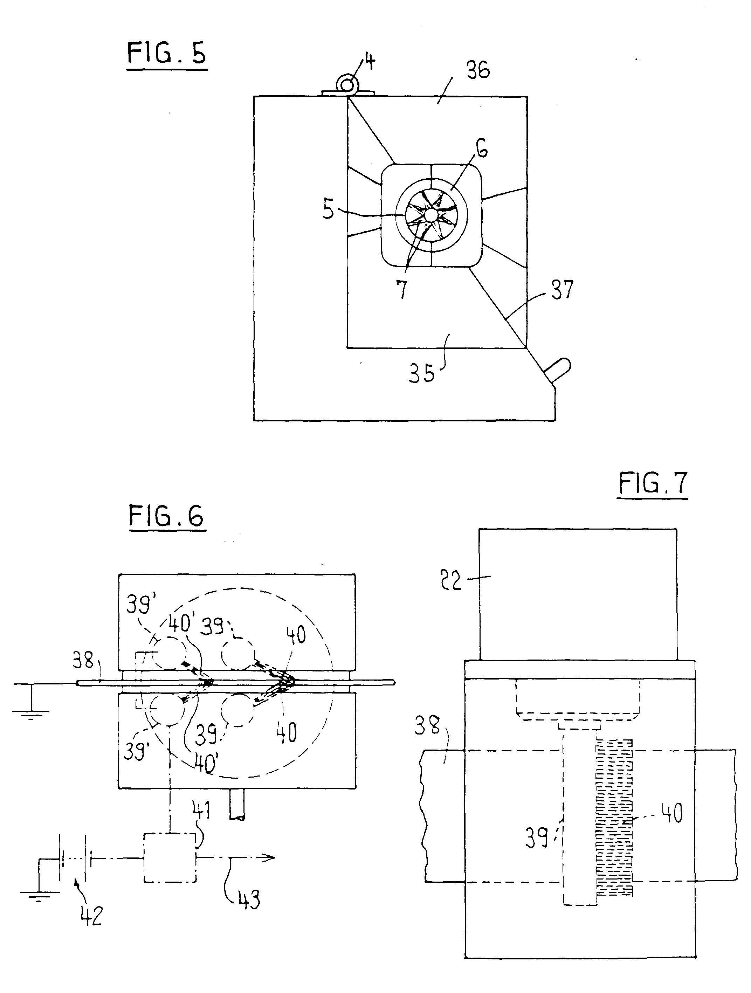

Fig. 4 zeigt ein Ausführungsbeispiel der Kreise 19 und 20 bei der Wechselspannungsausführung gemäss Fig. 3. An den Eingang dieser Schaltung gelangt von der Sekundärwicklung 28 im normalen Betrieb bei einer Frequenz von 50 bis 3000 Hz eine praktisch konstante Wechselspannung. Das Bandfilter 19 unterdrückt Signale unter 50 Hz und über 1 MHz. Damit werden kapazitive Stromänderungen im Niederfrequenzbereich und das weisse Rauschen im Hochfrequenzbereich infolge Koronaeffekten unterdrückt. Nur die relevanten Signale im oben erwähnten Durchlassbereich, also von den Durchschlagimpulsen, werden durchgelassen. Im unteren Zweig der Schaltung wird am Punkt 32 über ein Bandfilter 19' mit Durchlassbereich entsprechend dem Bereich der Arbeitsfrequenz und eine Diode 33 eine positive Spannung aufgebaut, die der Spannung des Eingangssignals, bzw. der Prüfspannung an der Elektrode 7 etwa proportional ist. In Fig. 4 ist der Verlauf der Regelspannung angedeutet. Durch die Vergleichsschaltung 20 werden daher an einen Zähler 34 nur Impulse übertragen, deren Niveau über der Vorspannung am Punkt 32 liegt. Es erfolgt damit eine Regelung des Ansprechniveaus, das mit steigender Prüfspannung entsprechend der Funktion des Regelgliedes 33' ansteigt.

Fig. 5 zeigt schematisch eine ähnliche Anordnung wie Fig. 1 mit dem Unterschied, dass Gehäuseteile 35 und 36 um eine geneigte Ebene 37 geschwenkt werden können. Die übrigen Teile sind gleich bezeichnet wie in Fig. 1. Von Bedeutung ist hierbei, dass die Fuge zwischen den Elektrodenträgern 5 und 6 vertikal liegt, derart, dass eventuell vom durchlaufenden Kabel oder Draht zugeführte Flüssigkeit, z.B. Kühlwasser, durch die untere Fuge abfliessen kann.

Die Fig. 6 und 7 zeigen schematisch eine Ausführung für ein bandförmiges Kabel 38. An stabförmigen Elektrodenträgern 39 sind langgestreckte Carbonfaserbürsten 40 angebracht, deren Fasern gleichmässig an den Flach- und Schmalseiten des Kabels 38 anliegen. Wie in Fig. 7 angedeutet, ist das Gehäuse mit den Prüfelektroden direkt mit dem Hochspannungstransformator 22 zusammengebaut.

Das Filter 19 gemäss Fig. 2 und der Kreis 20 zur Steuerung des Ansprechpegels sind ähnlich aufgebaut und arbeiten entsprechend wie der Kreis nach Fig. 4. Wenn die Spannung an der Elektrode 7 bei einem Durchschlag zusammenbricht, wird über den Kondensator 18 ein Impuls übertragen, dessen negative Vorderflanke durch entsprechende Schaltung der Diode 33 und entsprechend negative Vorspannung am Punkt 32 erfasst werden kann. Es könnte aber auch die positive Rückflanke des Impulses durch die Schaltung gemäss Fig. 4 erfasst werden. Das über den Kondensator 18 übertragene Rauschen, das mit ansteigender Prüfspannung zunimmt, wird gleichgerichtet und dient als Vorspannung zur Regelung der Ansprechschwelle im Sinne der Fig. 4, wobei diese Vorspannung, wie erwähnt, positiv oder negativ sein kann.

In vielen Fällen ist es erwünscht, zwischen Isolationsfehlern bei welchen ein Durchschlag von der Elektrode zum Leiter erfolgt und grösseren blanken Stellen, bei welchen ein Kurzschluss zwischen der Elektrode und dem Leiter erfolgt, zu unterscheiden. Zu diesem Zweck kann ausser den oben beschriebenen Anlageteilen zur Ermittlung von Durchschlägen bei Isolationsfehlern mit einer Prüfspannung über 800 V und Koronabildung eine weitere Messstelle vorgesehen werden, an welcher mit niedrigeren Spannungen von unter 800 V und ohne Koronabildung grössere blanke Stellen ermittelt werden. Eine solche Ausführung ist in Fig. 6, nicht aber in Fig. 7, in strichpunktierten Linien angedeutet. Demnach ist ein zweites Paar von Elektrodenträgern 39' mit Carbonfaserbürsten 40' als Elektroden vorgesehen, das mit einem Relais 41 verbunden ist. Diese Elektroden sind über das Relais 41 mit einer Spannungsquelle 42 verbunden. Gelangt eine blanke Stelle in den Bereich der Elektroden 40', entsteht an dieser Stelle eine direkte leitende Verbindung und es fliesst ein Strom über das Relais 41, welches über eine Leitung 43 ein Ausgangssignal z.B. an einen Zähler abgibt, welcher die Anzahl blanker Stellen zählt und anzeigt. Die Carbonfaser-bürsten haben auch in dieser Anwendung den Vorteil, dass sie die Oberfläche des zu prüfenden Objekts praktisch lükkenlos bedecken und somit auch kleine blanke Stellen mit Sicherheit erfassen. Die Bürstenausbildung und -anordnung ist dabei dem Objekt anzupassen, z.B. gemäss Fig. 1.

## Patentansprüche

1. Verfahren zum Erfassen von Isolationsfehlern, wobei mittels die Isolationsoberfläche berührender Elektroden eine Prüfspannung angelegt wird und von Durchschlägen verursachte Impulse gezählt werden,
**dadurch gekennzeichnet,**
daß die Prüfspannung mittels Bürsten (7) aus Carbonfasern angelegt wird und auf einen Sollwert in einem Bereich von 800 bis 5000 V geregelt wird.

2. Verfahren nach Anspruch 1, wobei eine Wechselspannung angelegt wird,
**dadurch gekennzeichnet,**
daß die Verlustleistung über einen Resonanzkreis (23, 24, 31) auf ein Minimum reduziert wird.

3. Verfahren nach Anspruch 2,
**dadurch gekennzeichnet,**
daß ein Hochspannungstransformator (22 - 24) einen Teil des Resonanzkreises (23, 24, 31) bildet.

4. Verfahren nach einem der Ansprüche 1 bis 3,
**dadurch gekennzeichnet,**
daß durch eine Messung der durch Rückwirkung der Meßgutimpedanz auf die Primärseite des Hochspannungstransformators (22 - 24) bedingten Phasenverschiebung zwischen einem Oszillator (11) und dem Resonanzkreis (23, 24, 31) eine kontinuierliche Regelung der Resonanzbedingung erzielt wird.

5. Verfahren nach einem der Ansprüche 1 bis 4,
**dadurch gekennzeichnet,**
daß aus einem die Impulse enthaltenden Meßsignal mittels Filter Störsignale eliminiert werden.

6. Verfahren nach einem der Ansprüche 1 bis 5,
**dadurch gekennzeichnet,**
daß die Impulse mit einem von der Prüfspannung abhängigen Ansprechniveau erfaßt werden.

7. Verfahren nach einem der Ansprüche 1 bis 6,
**dadurch gekennzeichnet,**
daß mittels weiterer Bürsten (40') aus Carbonfasern an einer anderen Meßstelle eine niedrigere Prüfspannung im Vergleich zur Prüfspannung an der ersten Meßstelle, von z.B. unter 800 V, zur Ermittlung blanker Stellen angelegt wird.

8. Sparktester zur Durchführung des Verfahrens nach Anspruch 1,
**gekennzeichnet durch**
Bürsten (7) aus Carbonfasern und einem Prüfspannungsgenerator (9, 11, 22) für zur Koronabildung an den Carbonfaserenden ausreichenden Prüfspannungen.

9. Tester nach Anspruch 8,
**dadurch gekennzeichnet,**
daß die Bürsten (7) aus Carbonfasern an teilbaren, schwenkbar miteinander verbundenen Elektrodenträgern (5, 6) angebracht sind.

10. Tester nach Anspruch 8 oder 9,
**dadurch gekennzeichnet,**
daß ein Hochspannungstransformator (22 - 24) einen Teil eines Resonanzkreises (23, 24, 31) bildet.

11. Tester nach einem der Ansprüche 8 bis 10,
**gekennzeichnet durch**
eine Resonanzfrequenzregelung (30) für die Wechsel-Prüfspannung zur Minimierung der Verlustleistung.

12. Tester nach einem der Ansprüche 8 bis 11,
**gekennzeichnet durch**
einen Bandfilter (19) für das Meßsignal.

13. Tester nach einem der Ansprüche 8 bis 12,
**gekennzeichnet durch**
einen Durchschlag-lmpulsdetektor (20) mit in Abhängigkeit der Prüfspannung regelbarem Ansprechniveau.

14. Tester nach einem der Ansprüche 8 bis 13,
**gekennzeichnet durch**
zusätzliche Bürsten (49') aus Carbonfasern, die über eine Auswertungsschaltung (41), z.B. einem Relais, mit einer Prüfspannungsquelle (42) mit einer zur Koronabildung an den Carbonfaserenden der Prüfelektroden nicht ausreichenden Spannung verbunden sind.

## Claims

1. Method of detecting insulation faults, wherein by means of electrodes touching the insulation surface a test voltage is applied and pulses caused by sparkovers are counted. characterised in that the test voltage is applied by means of brushes (7) of carbon fibres and is regulated at a reference value in a range from 800 to 5000 V.

2. Method according to claim 1, wherein an alternating voltage is applied. characterised in that the loss power is reduced to a minimum via a resonant circuit (23, 24, 31).

3. Method according to claim 2, characterised in that a high-voltage transformer (22-24) forms part of the resonant circuit (23, 24, 31).

4. Method according to one of claims 1 to 3, characterised in that by a measurement of the phase displacement between an oscillator (11) and the resonant circuit (23, 24, 31) caused by phase effect of the impedance of the object to be measured on the primary side of the high-voltage transformer (22-24) continuous regulation of the resonant condition is obtained.

5. Method according to one of claims 1 to 4, characterised in that from a measuring signal containing the pulses the interference signals are eliminated by means of a filter.

6. Method according to one of claims 1 to 5, characterised in that the pulses are detected with a response level dependent on the test voltage.

7. Method according to one of claims 1 to 6, characterised in that by means of further brushes (40') of carbon fibres, at another measuring point, a lower test voltage compared to the test voltage at the first measuring point. of e.g. less than 800 V is applied to detect uninsulated spots.

8. Spark tester for carrying out the method according to claim 1. characterised by brushes (7) of carbon fibres and a test voltage generator (9, 11, 22) for test voltages sufficient to form a corona at the carbon fibre ends.

9. Tester according to claim 8, characterised in that the brushes (7) of carbon fibres are mounted on divisible electrode carriers (5. 6) which are pivotably connected together.

10. Tester according to claim 8 or 9, characterised in that a high-voltage transformer (22-24) forms part of a resonant circuit (23, 24, 31).

11. Tester according to one of claims 8 to 10, characterised by resonant frequency regulation (30) for the alternating test voltage in order to minimise power loss.

12. Tester according to one of claims 8 to 11, characterised by a band filter (19) for the measuring signal.

13. Tester according to one of claims 8 to 12, characterised by a sparkover pulse detector (20) with a response level capable of being regulated as a function of the test voltage.

14. Tester according to one of claims 8 to 13. characterised by additional brushes (49') of carbon fibres, which via an evaluating circuit (41), e.g. a relay. are connected to a test voltage source (42) with a voltage not sufficient to form a corona at the carbon fibre ends of the test electrodes.

## Revendications

1. Procédé pour détecter des défauts d'isolation, selon lequel on applique une tension de contrôle au moyen d'électrodes placées en contact avec la surface d'un isolant et on compte des impulsions provoquées par des claquages, caractérisé en ce qu'on applique la tension de contrôle au moyen de balais (7) formés de fibres de carbone et on la règle sur une valeur de consigne se situant dans la gamme de 800 à 5000 V.

2. Procédé selon la revendication 1, selon lequel on applique une tension alternative, caractérisé en ce qu'on réduit au minimum la puissance dissipée au moyen d'un circuit résonnant (23, 24, 31).

3. Procédé selon la revendication 2, caractérisé en ce qu'un transformateur à haute tension (22-24) forme une partie du circuit résonnant (23, 24,31).

4. Procédé selon l'une des revendications 1 à 3, caractérisé en ce qu'à l'aide d'une mesure de déphasage, qui est conditionné par la réaction de l'impédance du matériau de mesure sur le côté primaire du transformateur à haute tension (22-24), entre un oscillateur (11) et un circuit résonnant (23, 24, 31), on obtient une régulation continue de la condition de résonance.

5. Procédé selon l'une des revendications 1 à 4, caractérisé en ce qu'on élimine des signaux parasites au moyen d'un filtre dans un signal de mesure contenant les impulsions.

6. Procédé selon l'une des revendications 1 à 5, caractérisé en ce qu'on détecte les impulsions ayant un niveau de réponse qui dépend de la tension de contrôle.

7. Procédé selon l'une des revendications 1 à 6, caractérisé en ce qu'à l'aide d'autres balais (40') formés de fibres de carbone on applique, en un autre point de mesure, une tension de contrôle inférieure à la tension de contrôle appliquée au premier point de mesure, et par exemple inférieure à 800 V pour détecter des zones nues.

8. Testeur à étincelles pour la mise en oeuvre du procédé selon la revendication 1, caractérisé par des balais (7) formés de fibres de carbone et un générateur (9, 11, 22) de tensions de contrôle servant à produire des tensions de contrôle qui sont suffisantes pour la création de l'effet couronne au niveau des extrémités des fibres de carbone.

9. Testeur selon la revendication 8, caractérisé en ce que les balais (7) formés de fibres de carbone sont montés sur des supports d'électrodes (5 6), qui peuvent être subdivisés et sont reliés entre eux de manière à pouvoir pivoter.

10. Testeur selon la revendication 8 ou 9, caractérisé en ce qu'un transformateur à haute tension (22-24) fait partie d'un circuit résonnant (23, 24, 31).

11. Testeur selon l'un des revendications 8 à 10, caractérisé par une unité (30) de régulation de la fréquence de résonance pour la tension de contrôle alternative pour réduire au minimum la puissance dissipée.

12. Testeur selon l'une des revendications 8 à 11, caractérisé par un filtre passe-bande (19) pour le signal de mesure.

13. Testeur selon l'une des revendications 8 à 12, caractérisé par un détecteur d'impulsions de claquage (20) comportant un niveau de réponse réglable en fonction d'une tension de contrôle.

14. Testeur selon l'une des revendications 8 à 13, caractérisé par des balais supplémentaires (49') formés de fibres de carbone, qui sont reliés par l'intermédiaire d'un circuit d'exploitation (41), par exemple un relais, à une source de tension de contrôle (42) délivrant une tension qui n'est pas suffisante pour créer l'effet couronne au niveau des extrémités des fibres de carbone des électrodes de contrôle.
